Europäisches Patentamt

**European Patent Office**

Office européen des brevets

(11) Publication number: **0 095 023**
**A2**

(12) # EUROPEAN PATENT APPLICATION

(21) Application number: **83102542.4**

(51) Int. Cl.³: **H 03 K 13/24**

(22) Date of filing: **15.03.83**

(30) Priority: **20.05.82 US 380386**

(43) Date of publication of application:
**30.11.83 Bulletin 83/48**

(84) Designated Contracting States:
**BE CH DE FR GB IT LI NL SE**

(71) Applicant: **International Business Machines
Corporation
Old Orchard Road
Armonk, N.Y. 10504(US)**

(72) Inventor: **Aaron, Robert Thomas
126 Carolyn Lane
Nicholasville, KY 40356(US)**

(72) Inventor: **Cassada, Thomas Edward
472 Lakeshore Drive
Lexington, KY 40502(US)**

(72) Inventor: **Krieg, Michael LeRoy
316 Taylor Drive
Lexington, KY 40505(US)**

(74) Representative: **Siccardi, Louis
COMPAGNIE IBM FRANCE Département de Propriété
Industrielle
F-06610 La Gaude(FR)**

(54) Contact keyboard with finger controlled N-key rollover.

(57) A keyboard (17) has plural keys (15) arranged for conventional touch keying. Each key (15) has an associated contact switch and the switches are electrically arranged in matrix form. Electrically connected columns of switches correspond to keys (15) actuated by a common finger (14) in conventional touch keying. Each switch in an electrically connected column of switches is connected to a different one of row sense lines. A two or three key rollover function with phantom key lockout is provided by a microprocessor which ignores simultaneous switch closures of switches (37) located in a common column of electrically connected switches.

./...

FIG. 4

CONTACT KEYBOARD WITH FINGER CONTROLLED N-KEY ROLLOVER


## Background of the Invention


### Field of the Invention

This invention relates to electronic contact keyboards and more specifically, to the electrical arrangement of the electronic drive and sense components of a contact keyboard with respect to the physical arrangement of the keys.


### Description of the Prior Art

Prior art contact keyboards include contact switches which are responsive to key depression to effect contact closure. The contact switches are electrically arranged in a matrix of electrically interconnected columns and electrically interconnected rows. Each column of switches is exclusively sequentially energized and simultaneously, each of the rows of switches are sensed in order to determine whether a switch has been closed by key depression. If a switch is closed, the energized column drive line is connected by the closed switch to a row sense line which provides an electrical signal to a sensing circuit. In such an arrangement, multiple simultaneous switch closure can create back circuits causing the sensing circuit to sense a false switch closure. Numerous prior art systems exist to prevent such phantom key sensing. One well known approach disclosed for example in US-A-3,778,818, is to electrically isolate each switch with a diode so that back circuits are not created and to associate a bistable element with each switch. This approach adds great expense to the keyboard but has the advantage that any number of keys may be simultaneously operated and correctly sensed. This advantage is often referred to as N-key rollover.

Another prior art approach to prevent phantom key sensing is to lockout all key sensing when multiple switches are closed until the multiple switch closure is eliminated by the re-

**0095023**

lease of keys. This approach interferes with normal operator keyboarding since operators often depress a first key and then a second key prior to the release of either key. When the lockout scheme is employed, the second key is often not recognized, especially if it is the first to be released.

A still further variation of the lockout scheme recognizes that a phantom key will not be sensed as long as three keys are not depressed simultaneously. Thus the lockout does not occur until three keys are depressed. Such schemes are referred to as two key rollover with phantom key lockout. U.S. Patent 4,106,011 describes a scheme allowing three key rollover and various other schemes are known which electrically enhance three key rollover.

While the foregoing lockout schemes allow some multiple key depression, they do not allow proper keyboarding in many situations wherein four or more keys are simultaneously depressed. This situation has been known to interrupt keying rhythm as when, for example, all characters of a familiar word such as "the" or "and" along with the spacebar are depressed in rapid succession.

<u>Summary</u>

In order to provide the keyboard operator or typist with the advantage of N-key rollover allowing (in the extreme situation) all fingers to correctly depress keys simultaneously without appreciably adding to the cost of the keyboard, we have physically arranged our keyboard so that all key operated switches normally actuated by a single finger using conventional touch typing techniques are electrically interconnected to a common column drive line. Each such key switch connected to a common column drive line is also connected to a unique sense line. It is only when simultaneous actuation of two or more keys that normally are depressed by a single finger are simultaneously depressed that a key lockout is effected. Since this does not occur with normal touch typing, a touch typist would not encounter key lockout which would interfere with the operator typing rhythm.

The foregoing and other features and advantages of this invention will be apparent from the following more.particular description of the preferred embodiment of the invention as illustrated in the accompanying drawings.

## In The Drawings

FIG. 1 is an illustration of a typical typewriter keyboard showing the relationship of a typist's fingers to the keys in typical touch typing.

FIG. 2 is a schematic diagram of the electrical keyboard drive and sense components illustrating the relationship of the drive lines to the fingers of a typist.

FIG. 3 is a schematic diagram of a key and its associated switch.

FIG. 4 is an illustration of a circuit card drive line layout and key switch contacts of the keyboard of the present invention.

FIG. 5 is an illustration of a circuit card sense line layout and key switch contacts of the keyboard of the present invention.

FIGS. 6 and 7 are sequential diagrams of the operations performed by the microprocessor of FIG. 1 in detecting key depression.

## Detailed Description

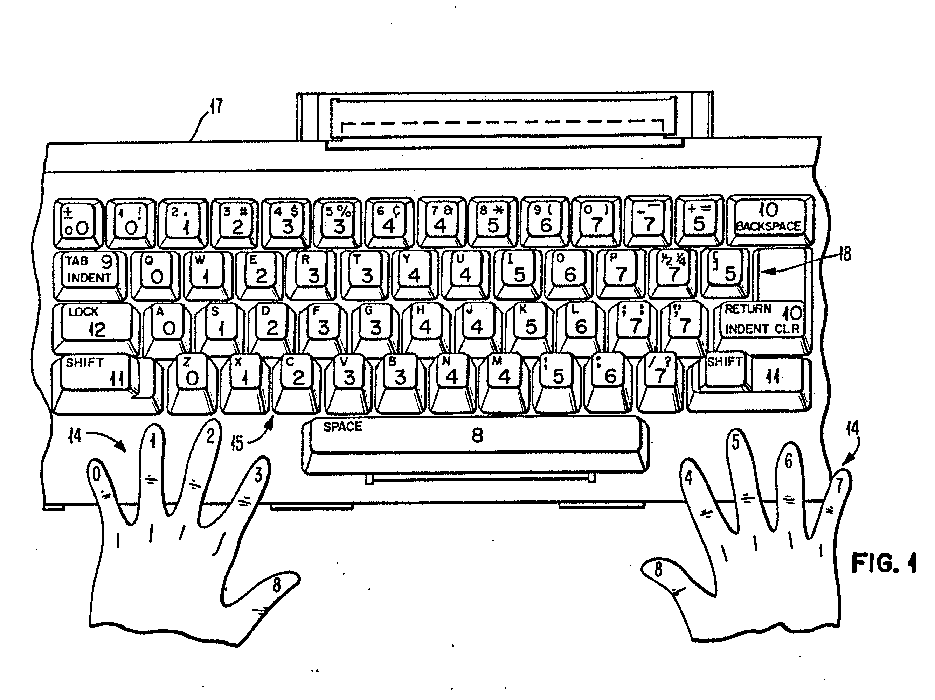

Referring now to the drawings, and more particularly to FIG. 1 thereof, there is illustrated the relationship of a typist's fingers 14 to the keys 15 of a keyboard 17 when the

4    0095023

keys 15 are used for typical touch typing. Each of the keys 15 are labeled with small alphabetic, numeric or symbol legends corresponding to symbols appearing on a typical typewriter keyboard well known to users. This keyboard 17 is often referred to as a "Qwerty" keyboard thusly named for the sequential arrangement of the first six keys in the third row 18 of the keyboard 17.

Each key 15 is also labeled with one of the larger numeric labels 0-12. Those keys 15 having labels 0-8 are actuated by corresponding fingers 14 labeled 0-8 in typical touch typing. For example, those keys having the small legend 3, E, D, and C also have a large label "2" thereon indicating that they are actuated by the finger 14 labeled "2" in typical touch typing. In a similar manner, those keys 15 having the large label 3 thereon are actuated by the finger 14 labeled 3 and so on. The keys 15 having the large label 9-12 are special function keys which are usually actuated by the outermost fingers 14 labeled 0 and 7 but more typically, may also be actuated by any other finger 14 during normal typing since they cause an associated machine (not shown) to undergo functional change in contradistinction to effecting printing cycles.

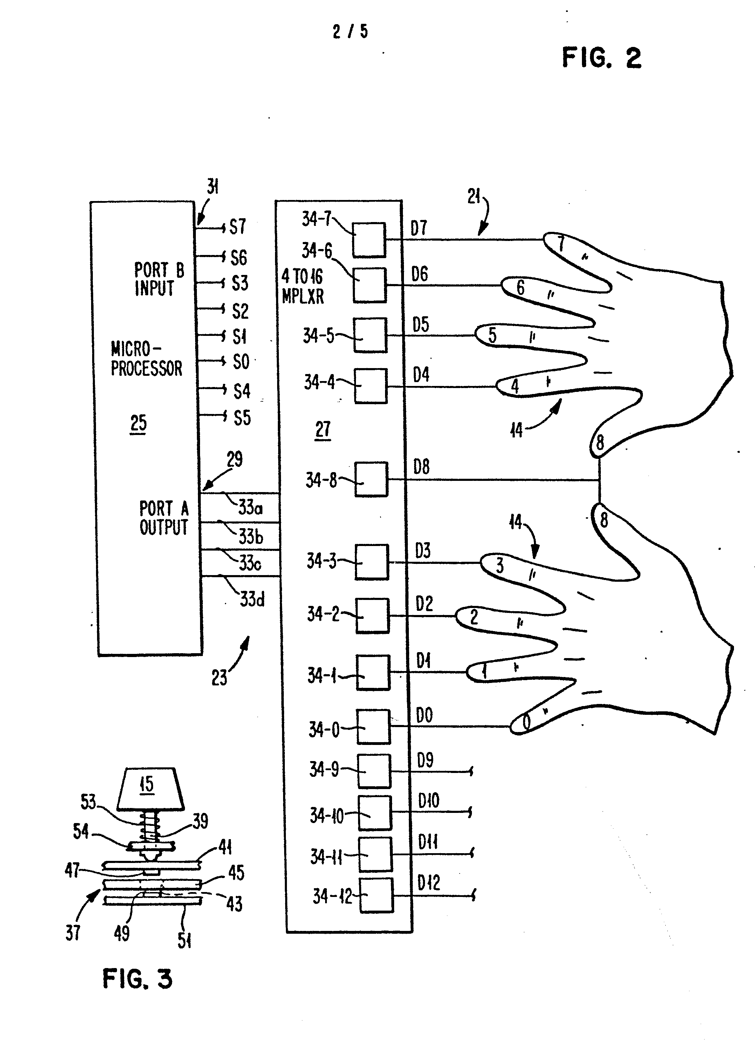

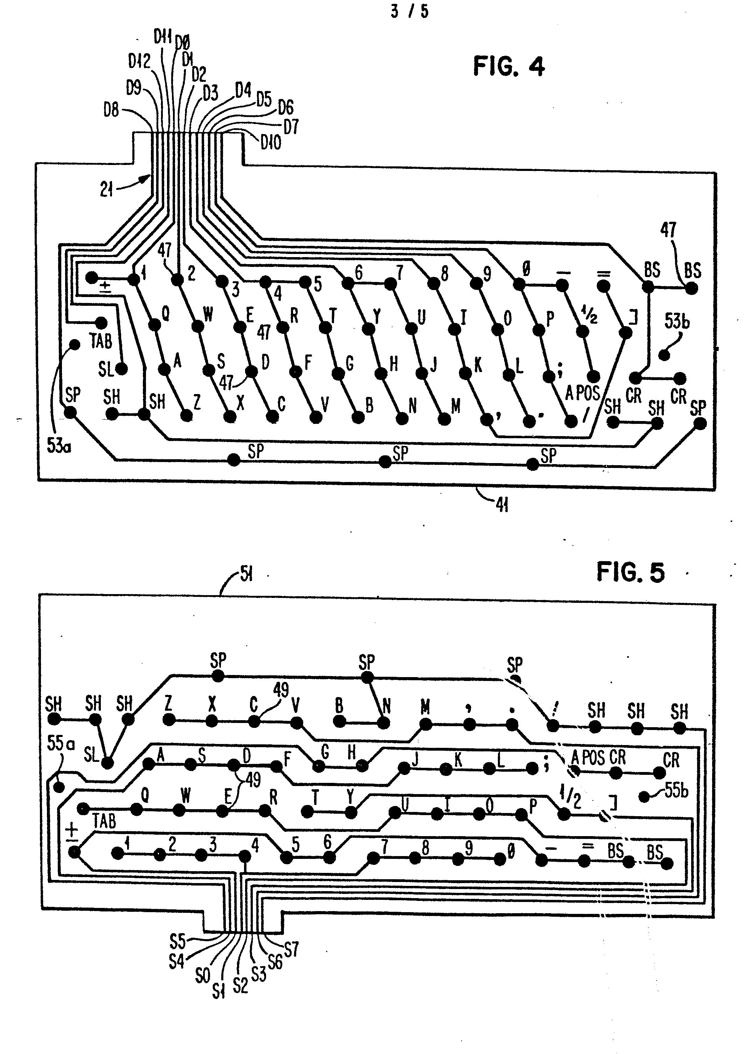

As will be described with respect to FIGS. 2 and 4 of the drawings, all keys 15 having the same large label thereon have associated components which are electrically interconnected one to another. At any given instant of time, only those keys 15 having the same large numeric label thereon are simultaneously sampled to determine whether any of them have been actuated. Thus, for example, at a given instant of time, the keys 15 having the small legend 3, E, D and C and the large label 2 are all simultaneously sampled in order to determine whether they have been actuated. Since all of these keys 15 having the large label 2 thereon are actuated by the same finger 14 labeled 2 during normal touch typing, it is highly unlikely that an operator would simultaneously depress plural ones of these keys 15 in a non-error condition. In contradistinction, the keys 15 labeled "T", "H", "E", and "SPACE" could be rapidly sequentially actuated by fingers 14 labeled 3, 4, 2 and 8 so that all of these keys 15 would be simultaneously depressed in a non-error condition.

Referring now to FIG. 2 of the drawing, an illustration of the relationship of the fingers 14 labeled 0-8 of a typist to the electrical keyboard 17 drive lines 21 of the electrical keyboard 17 drive and sense components 23 is depicted. The drive lines 21 labeled D0-D12 are correspondingly associated with the keys 15 labeled 0-12. For example, drive line D2 is associated with those keys 15 of FIG. 1 having a large label 2 thereon as will be further explained with respect to FIG. 3 of the drawings. It is through this relationship that the drive lines 21 correspond to the fingers 14 labeled 0-8 as schematically illustrated.

The drive lines 21 are sequentially electrically energized under the control of the microprocessor 25 and the multiplexor 27. The microprocessor 25 may be an Intel 8048/8049 microprocessor having a port A output 29 and a port B input 31. The microprocessor 25 is programmed to provide sequential output signals at the port A output 29 on the four lines 33a, 33b, 33c and 33d emanating therefrom. The multiplexor 27 converts the four timewise spaced signals appearing on its input lines 33a-33d to sixteen unique time spaced signals, thirteen of which appear on its output drive lines 21 labeled D0-D12. A drive circuit 34-7 is connected to the drive line 21 labeled D7 and like circuits 34 are connected to each other drive line 21.

The port B input 31 of the microprocessor 25 has connected thereto eight input lines S0-S7 which provide the microprocessor 25 with sensed information which indicates key 15 depression as will be described.

Referring now to FIG. 3 of the drawings, there is depicted a schematic diagram of a key 15 and its associated switch 37. Depression of the key 15 causes it associated actuator 39 to press downward on the flexible circuit card 41. This action causes the circuit card 41 to deflect through an aperture 43 in the separator card 45 so that its contact 47 physically touches the contact 49 located on the circuit card 51. A spring 53 grounded on frame 54 returns the key 15 to its initial position when it is released by the operator allowing the flexible circuit card 41 to return to its initial noncontacting position. When the contacts 47 and 49 physically touch one another, the switch 37 is closed, otherwise the switch 37 is open. Numerous forms of switch actuators and electrical contact switches as are well known in the art may be employed with our invention.

Referring now to FIG. 4 of the drawings, an illustration of the circuit card 41, drive line 21 layout and key switch contacts 47 are depicted. Each of the drive lines 21 labeled D0-D12 correspond to like labeling in FIG. 2 and are connected to various ones of the contacts 47. It is noted that each contact 47 is connected only to a single drive line 21. The contacts 47 are labeled with letters, numerals and symbols which correspond to similar labels on keys 15 in FIG. 1. Thus, for example, the drive line D2 is connected to the contacts 47 labeled 3, E, D and C. It will be recalled that the keys 15 of FIG. 1 having the same legends, are actuated by finger 14 of FIG. 1 labeled 2. Thus, when the drive line D2 is sequentially energized by the multiplexor 27 of FIG. 2, only the contacts 47 labeled 3, E, D and C are energized. Thus, only these contacts 47 may be sampled by the microprocessor 25 at that instant of time when it is caused to scan the signals appearing at its port B input 31 of FIG. 2.

Referring now to FIG. 5 of the drawing, there is depicted an illustration of the circuit card 51 and its contacts 49. The contacts 49 are labeled so that they correspond with the labeling of FIG. 4 and FIG. 1. The circuit card 41 is aligned with the circuit card 51 through the utilization of alignment holes 53a and 53b on card 41 of FIG. 4 with holes 55a and 55b respectively on the card 51 of FIG. 5.

The sense lines S0-S7 are each uniquely connected to a row series of contacts 49, there being one unique sense line S0-S7 connected to each contact 49. The number of sense lines S0-S7 correspond to the maximum number of keys 15 of FIG. 1 which are actuated by a single finger (e.g., those keys 15 having the large numerals 3 and 4 located thereon).

Each of the keys 15 which are actuated by a single finger, and thus connected to a common drive line 21 of FIG. 4, is connected to a different sense line S0-S7. Thus, for example, the keys 15 labeled 3, E, D, and C have their associated contacts 49 respectively connected to the sense lines S1, S2, S4 and S6. As has been described, these keys 15 are also associated with a common drive line D2 of FIG. 4. Thus, when the drive line D2 is energized with an electrical signal, the sensing of a corresponding signal on line S2 by the microprocessor 25 of FIG. 2 would indicate that the key 15 labeled "E" had been depressed causing the contact 47 labeled "E" to physically contact the contact 49 labeled "E".

If multiple keys 15 connected to a common drive line are simultaneously depressed, there would be multiple sense lines S0-S7 having electrical signals thereon simultaneously. When this occurs, it is possible to create back circuits which would provide a false indication of a key 15 actuation upon the energization of a subsequent drive line 21. Since it is desirable to avoid this situation, a sequence of operations is performed by the microprocessor 25 to prevent or lockout the sensing of key 15 actuations as long as two keys 15 connected to a common drive line 21 are depressed.

There are four different conditions applicable to each switch 37 of FIG. 3 which are recognized by the microprocessor 25 of FIG. 2: switch 37 open; switch 37 closed; switch 37 changing state from open to closed; and switch 37 changing state from closed to open. Additionally, the microprocessor 25 must recognize when plural switches 37 associated with a single drive line 21 are simultaneously closed to provide a lockout function.

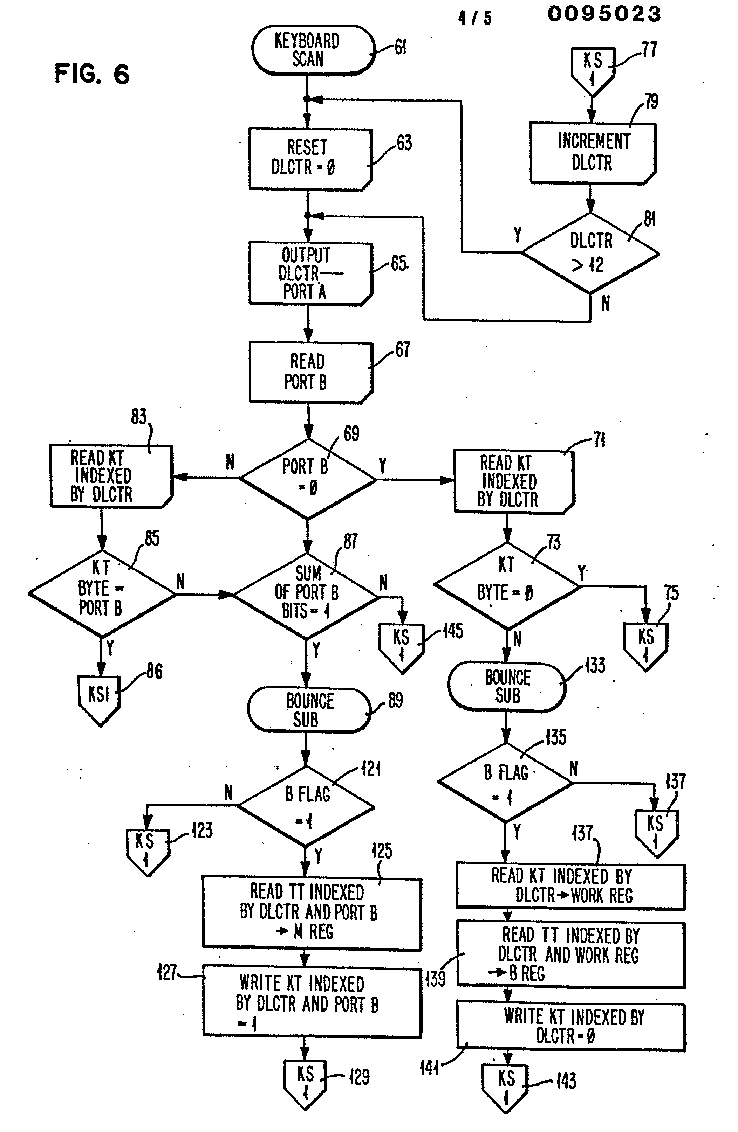

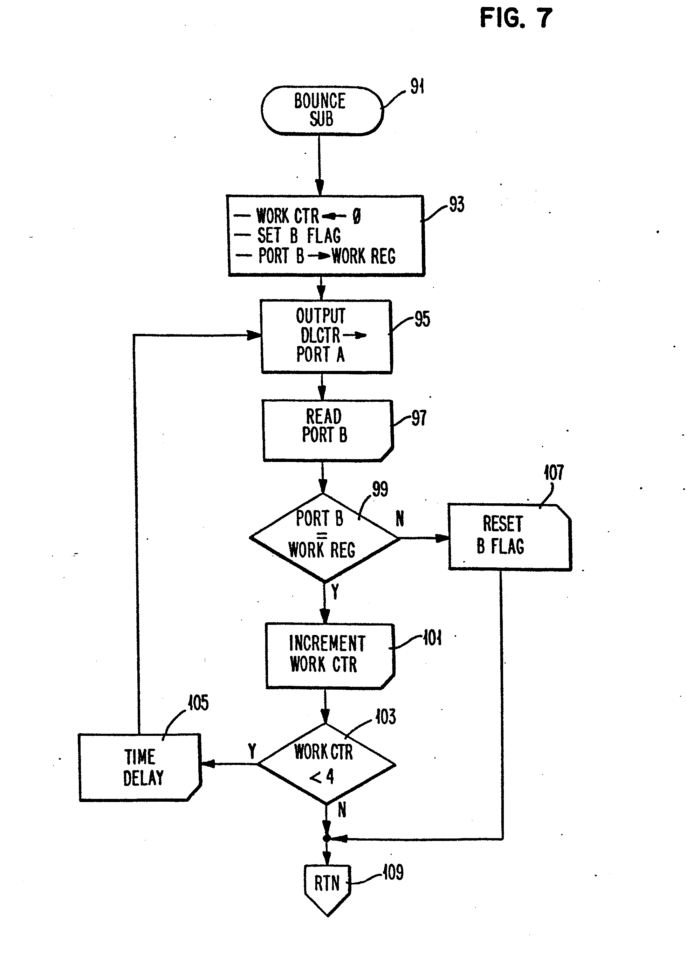

Referring now to FIGS. 6 and 7 of the drawings, sequential diagrams of the operations performed by the microprocessor 25 of FIG. 2 are depicted. The operation most typical of the switch 37 condition is that the switch 37 is open (e.g., its corresponding key 15 is not operated). When the microprocessor 25 of FIG. 2 effects a keyboard scan operation, and no keys 15 are depressed, the following operations occur.

The keyboard scan is initiated as indicated by block 61 and the first operation to be performed is illustrated by block 63 wherein a drive line counter (DLCTR) is set equal to zero. The drive line counter can be a simple register or storage location defined by the microprocessor 25 and located therein. The output of the drive line counter is next outputted to the port A output 29 of FIG. 2 as denoted by block 65. This, in turn causes the drive line 21 labeled D0 in FIG. 2 to be activated. Thereafter, port B input 31 of FIG. 2 is caused to be read as denoted by block 67. Typically, the information appearing on the lines S0-S7 of FIG. 2 is stored in a temporary register of the microprocessor 25 and its contents are then examined to determine whether the information on any of the lines is at a positive voltage level indicating switch 37 closure as indicated by block 69.

Assuming that none of the switches 37 have been closed, the operation proceeds to block 71. During this operation, a keyboard table storage area of the microprocessor 25 designated as KT as indexed by the drive line counter information is read out. The information represents the information which previously appeared on the sense lines as S0-S7 during a prior scan of key switches 37 activated by the same output of the drive line counter. Since during this operation it is assumed that no information was present during the prior scan, a test is performed at block 73 on the information accessed by block 71 and causes the operation proceed through connector blocks 75 and 77 to block 79 wherein the drive line counter is incremented by one. As indicated by block 81, the contents of the drive line counter is checked to insure that it is not greater than 12. If it is greater than 12, the drive line counter is reset to zero as indicated by block 63. Otherwise, the contents of the drive line counter is outputted to port A output 29 as indicated by block 65 and the operation is repeated for the next subsequent column of switches 37 to be scanned. In this manner, the columns of switches 37 are sequentially scanned and this activity is again repeated until a key 15 is depressed causing switch 37 closure.

As has been described, when a switch 37 is closed, an electrical connection is established between the column driver 34 connected to that switch 37 and the sense line S0-S7 connected to that switch 37. When that particular column driver 34 is energized as noted by the operation 65, one of the sense lines S0-S7 assumes a voltage level which is detected as noted by block 69. At this time, the operation proceeds to block 83 wherein the keyboard table storage area KT as indexed by the drive line counter is read out. If the byte accessed from the keyboard table storage matches the information at the port B input 31, it is recognized that the key 15 had been depressed and recognized during a prior scan cycle and that there has thus been no change in state during the scan cycle underway. This decision is noted by block 85 and connector 86. In this situation, the operation proceeds until the key 15 is released as will be later described.

Assuming that a sensed switch 37 has just changed state, the information in the keyboard table storage representing the prior scan of that switch 37 would be zero while the information appearing at the port B input 31 would be one. Thus, the operation would proceed from block 85 to block 87 wherein a check is made to determine whether more than one switch 37 addressed by the same column drive circuit 34 has been closed. Assuming that only one such switch 37 has been closed, the bounce subroutine operation of FIG. 7 is entered as noted by block 89. The bounce subroutine operation of FIG. 7 insures that a switch 37 closure indication is not made based upon a brief noise spike or other electrical disturbance. This is effected by sequentially sampling the output of the switch 37 over a period of time to insure that the switch 37 has remained closed over that period of time.

Referring now to FIG. 7 of the drawings, once the bounce subroutine operation is initiated as indicated by block 91, a work counter is set equal to zero, a B flag is set in a fixed register and the signal sensed at the port B input 31 is set into a work register as noted by block 93. The drive line counter contents are then gated to the port A output 29 as noted by block 95 and the port B input 31 is then reread as noted by block 97. This input signal is compared with the contents of the work register as noted by block 99 and if the contents are the same indicating that the signal from the switch 37 has not changed, the work counter is incremented as noted by block 101. If the contents of the work counter is less than four, as noted by block 103, a fixed time delay is initiated at block 105 and the operation proceeds back to block 95. The operation thus remains in this loop until the contents of the work counter are equal to four indicating that the signal appearing at the port B input 31 has remained constant over three time delays or until the signal appearing at the port B 31 differs from the contents of the work register indicating the signal has changed. In this latter event, the B flag is reset as noted block 107. Thus the bounce subroutine operation returns to the operation which initiated it as noted by block 109 with a B flag set indicating switch 37 closure over a fixed period of time or with the B flag reset indicating a lack of switch 37 closure over the fixed period of time.

Referring once again to FIG. 6 of the drawings, if the B flag has been reset as indicated by block 121, the operation returns through block 123 so that continued scanning is effected with no indication of switch 37 closure. If the B flag is set, then the operation proceeds to block 125.

The operation specified by block 125 causes the proper character information to be logically identified and set into a
memory register so that it can be accessed by a utilization
device. Thus a translate table (TT) is addressed as indexed
by the output of the drive line counter and the information
content appearing at the port B input 31. In essence, the
column input as supplied by the drive line counter and the
row input as supplied by the active bit at the port B input
31 provides the key identification and the table provides the
character associated with that key to the M register. Thereafter, the keyboard table storage KT as indexed by the drive
line counter and the port B input 31 is accessed so that a
bit is written therein as noted by block 127. This bit will
be subsequently utilized to prevent the system from rereco-
gnizing the same closed switch 37. The operation then proceeds through the connector 129 to the connector 77.

The drive line counter is thereafter incremented as noted by
block 79 and the next column of switches 37 which are electrically interconnected is caused to be energized and the
switches 37 are sensed as noted by block 67. If an additional key 15 having an associated switch 37 connected to the
now energized drive line 21 has been depressed causing switch
37 closure, that key information is recognized as has just
been described. Otherwise the operation proceeds to blocks
71-75 as has been previously described until the column
containing the previously recognized depressed switch is
energized. At this time, the byte stored in the key table
storage KT as noted by block 83 would indicate that it is
non-zero since it had been set to one at block 127. By the
identity of the bytes in the key table storage KT and the
port B input 31, the operation proceeds through the connector
block 86 and the next drive line 21 is sampled.

Upon operator release of the key 15 associated with a previously closed switch 37, the operation proceeds to blocks 71
and 73 from block 69. Since the previously stored non-zero
bit in the key table storage KT would not match the zero bit

**0095023**

at the port B input 31, the operation would proceed to the bounce subroutine operation as noted by block 133. This subroutine operation would insure that the port B input 31 remained zero over a fixed period of time by setting a bounce flag as previously described. If the switch state 37 does not remain zero over the fixed time delay as noted by the lack of a bounce flag being set, the operation proceeds from this test noted by block 135 through the connector 137. The operation thus continues until a subsequent key 15 is depressed or until the key 15 is released.

If the key 15 is released, the bounce flag is set equal to one and the operation proceeds from block 135 to block 137 whereat the key table storage KT as indexed by the drive line counter is set into a work register. The translate table is then indexed by the drive line counter and the work register and gated into the B register for utilization by the system as noted by block 139. The contents of the B register tell the system that the particular key 15 has just been released. The key table storage KT is then indexed by the drive line counter and set equal to zero as indicated by block 141 and the operation proceeds through block 143 back to block 77.

If more than one key is indicated as being depressed in a single column of electrically interconnected switches 37, the operation detects this as previously described at block 87 and connects through block 145 back to block 77. This effectively prevents or locks out any switch 37 from being identified as having closed in that particular energized column of electrically interconnected switches 37. Thus, if two switches 37 are closed in a common column, those switches 37 are not identified by the system until one of the switches 37 is released.

Additionally, if a third switch 37, in a second column other than the common column, is closed which is connected to the same row sense line S0-S7 as one of the two switches 37 in the common column, a back circuit is created indicating that two switches 37 are closed in that second column. Although this is a false indication, the system nevertheless ignores both switches 37 in that column thus preventing the detection of a phantom key.

Various programming techniques may also be employed to allow recognition of multiple key 15 depressions in a single column of electrically connected switches 37. This may be done by first scanning all of the columns of switches 37 and storing an indication of any multiple switch 37 closure for each column scanned. If multiple key 15 depression has not occurred in more than one column, all sensed information is recognized as valid. If, however, multiple switch 37 closure is recognized in plural columns, then, none of the switches 37 located in a column having multiple switch 37 closure is recognized until the condition no longer exists. This thus provides a further level of rollover although it is recognized that it also allows recognition of potential error situations occasioned when a single finger causes the depression of two adjacent keys 15 by mistake.

It is of course recognized that it is desirable to minimize the number of drive lines 21 and drive circuits 34 in order to reduce both cost and keyboard 17 scan time. This is because each drive line 21 must be sequentially energized and remain energized over a period of time sufficient to provide an adequate switch 37 sample. The number of columns of switches 37 which are electrically connected by a common drive line 21 thus determine the total keyboard 17 scan time. While various scan sequencing schemes may be utilized to scan the outboard function keys 15 labeled 9-12 on a less frequent basis it has been found that each key 15 labeled 0-8 should be sampled within 10-15 milliseconds in order to insure correct keyboard 17 operation. Thus it is necessary from both a cost and a sampling time standpoint to sample plural switches simultaneously.

**0095023**

Our invention which groups the switches 37 according to the
finger 14 which normally operates its associated key 15 thus
provides a cost efficient keyboard 17 which correctly senses
depressed keys 15 while locking out only multiple simultaneous key 15 depression when the depressed keys 15 are those
normally operated by a single finger 14 in conventional touch
typing.

CLAIMS

1.  A contact keyboard (17) of the type comprising:

    a plurality of key actuators (39) arranged in a predetermined pattern,

    a plurality of contact switches (37) each responsive to a key actuator (39) and electrically arranged in a matrix form having rows and columns, the closure of a switch (37) electrically connecting a row and column together;

    plural column drivers (34) each sequentially operated for electrically energizing a column of electrically connected contact switches (37);

    row sensing means (S0-S7) for sensing an operated switch (37) in any energized column of switches (37);

    scan means (DLCTR) for sequentially actuating said column drivers (34) and for gating said row sensing means (S0-S7);

    logic means (25, MREG, TT) responsive to a said sensing means (S0-S7) and said scan means (DLCTR) for identifying specific key actuation in response to a column energized signal and a row sensing signal;

    said contact keyboard (17) being characterized in that:

    all contact switches (37), normally actuated by a single finger using conventional touch typing techniques, are electrically interconnected to a common column driver (34), each such contact being also connected to a unique row sensing means (S0-S7);

and it that it further includes :

detecting means (port B) for detecting plural switch closure of switches (37) electrically connected in a single column;

lockout means (25) responsive to said detecting means (port B) for preventing said logic means (25, MREG, TT) from identifying false key actuation.

2. The contact keyboard of Claim 1 wherein said lockout means (25) includes means for storing an indicator signal representative of plural switch closure for each of a plurality of electrically connected columns of switches (37), and means responsive to said storage means for preventing said logic means (25, MREG, TT) from identifying specific key actuations in response to plural stored indicator signals.

FIG. 1

17

18

14

15

14

1/5

0095023

| | | | | | | | | | | | | | | |
|---|---|---|---|---|---|---|---|---|---|---|---|---|---|---|
| ± O<br>o O | 1 !<br>O | 2 ·<br>1 | 3 #<br>2 | 4 $<br>3 | 5 %<br>3 | 6 ¢<br>4 | 7 &<br>4 | 8 *<br>5 | 9 (<br>6 | O )<br>7 | - _<br>7 | + =<br>5 | 10<br>BACKSPACE | |

TAB 9 INDENT | Q O | W 1 | E 2 | R 3 | T 4 | Y 4 | U 5 | I 6 | O 7 | P 7 | ½ ¼ 7 | ¢ 5 | 

LOCK 12 | A O | S 1 | D 2 | F 3 | G 3 | H 4 | J 4 | K 5 | L 6 | ; : 7 | " ' 7 | RETURN 10 INDENT CLR

SHIFT 11 | Z O | X 1 | C 2 | V 3 | B 3 | N 4 | M 4 | , ; 5 | . : 6 | / ? 7 | SHIFT 11

SPACE 8

**FIG. 2**

31

PORT B
INPUT

MICRO-
PROCESSOR

25

S7
S6
S3
S2
S1
S0
S4
S5

4 TO 16
MPLXR

27

34-7    D7
34-6    D6
34-5    D5
34-4    D4

34-8    D8

34-3    D3
34-2    D2
34-1    D1
34-0    D0
34-9    D9
34-10   D10
34-11   D11
34-12   D12

21

44

8

8

44

PORT A
OUTPUT

29

33a
33b
33c
33d

23

15

53
54
47
37
49
51

39
41
45
43

**FIG. 3**

**FIG. 4**

**FIG. 5**

FIG. 6

5 / 5

FIG. 7